**Europäisches Patentamt**

**European Patent Office**

**Office européen des brevets**

(19)

(11) Veröffentlichungsnummer: **0 137 121**
**B1**

(12) # EUROPÄISCHE PATENTSCHRIFT

(45) Veröffentlichungstag der Patentschrift:
08.03.89

(21) Anmeldenummer: **84107539.3**

(22) Anmeldetag: **29.06.84**

(51) Int. Cl.⁴: **H 03 C 1/62**

(54) Amplitudenmodulierter Sender mit Steuerung des Trägerwertes.

(30) Priorität: **12.08.83 CH 4406/83**

(43) Veröffentlichungstag der Anmeldung:
**17.04.85 Patentblatt 85/16**

(45) Bekanntmachung des Hinweises auf die Patenterteilung:
**08.03.89 Patentblatt 89/10**

(84) Benannte Vertragsstaaten:
**CH DE FR GB LI NL**

(56) Entgegenhaltungen:
DE-A-3 037 902
GB-A-502 013

RUNDFUNKTECHNISCHE MITTEILUNGEN, Band
26, Nr. 3, Mai-Juni 1982, Seiten 97-105, Norderstedt,
DE; G. PETKE: "Energiesparende
Modulationstechniken bei AM-Rundfunksendern"
HOCHFREQUENZTECHNIK UND
ELEKTROAKUSTIK, Band 47, Heft 5, Mai 1936,
Seiten 141-147, Leipzig, DD; HARBIG, GERTH UND
PUNGS: "Modulation mit veränderlichem
Trägerwert"

(73) Patentinhaber: BBC Brown Boveri AG,
Haselstrasse, CH- 5401 Baden (CH)

(72) Erfinder: Kyrian, Bohumil, Ursprung 293, CH- 5224
Unterbözberg (CH)

EP 0 137 121 B1

## Beschreibung

Die Erfindung betrifft einen amplitudenmodulierten Sender mit Steuerung des Trägerwertes gemäss dem Oberbegriff des Anspruchs 1.

Zur Verringerung der Stromkosten eines amplitudenmodulierten Rundfunksenders und unter Berücksichtigung der Empfängereigenschaften ist schon früh (Hochfrequenztechnik und Elektroakustik, Jahrbuch der drahtlosen Telegraphie und Telephonie, Bd. 47, Heft 5, Mai 1936, S. 141 ff.) ein Verfahren zur Modulation mit veränderlichem Trägerwert vorgeschlagen worden. Dieses als HAPUG-Modulation bekannte Verfahren sieht eine lineare Steuerung des Trägerwertes in Abhängigkeit vom Pegel des Modulationssignals vor, die den Trägerwert von einem Trägerrestwert beim Modulationspegel Null auf seinen maximalen Wert bei maximalen Modulationspegel aufwärtssteuert. Der Trägerrestwert begrenzt dabei den Einfluss einer gekrümmten Gleichrichterkennlinie im Empfänger auf die Qualität des demodulierten Rundfunksignals.

Ausgehend von dem HAPUG-Verfahren, ist weiterhin vorgeschlagen worden (DE-C-3 037 902), die Energieersparnis dadurch zu erhöhen, dass bei gleichbleibendem Trägerrestwert die Kennlinie der Trägersteuerung, zumindest im Bereich der am häufigsten vorkommenden Modulationspegel, unterhalb der HAPUG-Kennlinie verläuft. Im Extremfall bleibt dann der Trägerwert für kleinere Modulationspegel konstant und gleich dem Trägerrestwert und wird erst oberhalb eines bestimmten Pegelwertes entlang derjenigen Geraden aufwärtsgesteuert, die sich für einen Modulationsgrad von 100 % ergibt. Um die Gefahr einer Übermodulation zu verringern, kann zusätzlich der steilere Kennlinienteil zu kleineren Pegelwerten hin parallel verschoben sein.

Den beiden bekannten Verfahren zur Trägersteuerung ist Eines gemeinsam: Es besteht ein direkter Zusammenhang zwischen der Grösse des Trägerrestwertes und der erzielten Energieersparnis. Die Energieersparnis wird umso grösser, je kleiner der Trägerrestwert gewählt wird. Auf der anderen Seite geht mit der Verkleinerung des Trägerrestwertes eine Verringerung des Störspannungsabstandes am Empfangsort einher, die zu einer merklichen Verschlechterung der Empfangsqualität führt.

Für heutige und zukünftige Verhältnisse in den Rundfunkbändern mit ihrer hohen Senderdichte ist eine Trägerabschwächung auf 60 % der Nominalamplitude (Trägerrestwert 0,6), wie sie in der DE-C-3 037 902 vorgeschlagen worden ist, viel zu gross. Der Störspannungsabstand wird dadurch um etwa 4,4 dB verschlechtert, was vor allem in den Pausen und bei leisen Musikpassagen in den Randgebieten eines Sendebereichs eine deutliche Qualitätsminderung bedeutet. Wird der Träger aber nicht so stark gesenkt, erreicht man nicht die gewünschte Energieeinsparung.

Schliesslich ist es aus der GB-A-502 013 bekannt (siehe die dortige Fig. 2), den Träger von einem festen Trägerrestwert ausgehend zunächst linear auf einen unterhalb des Trägerrestwertes liegenden Minimalwert abzusenken, und dann von diesem Minimalwert linear aufwärtszusteuern.

Zwar bringt diese Lösung Vorteile gegenüber der konstanten Trägerkennlinie im unteren Pegelbereich. Jedoch wird auch hier nicht das volle Sparpotential ausgeschöpft, weil wiederum aufgrund der Trägerkennlinie die Energieeinsparung massiv von der Wahl des Trägerrestwertes abhängt.

Aufgabe der vorliegenden Erfindung ist es daher, eine Trägersteuerung zu finden, die eine optimale Wirtschaftlichkeit des Senders gewährleistet und den Störspannungsabstand gegenüber einem Sender ohne Trägersteuerung nur unwesentlich, d. h. höchstens um etwa 3 dB, verschlechtert.

Die Aufgabe wird bei einem Sender der eingangs genannten Art durch die Merkmale aus dem Kennzeichen des Anspruchs 1 gelöst.

Der Kern der Erfindung besteht darin, den engen Zusammenhang zwischen dem minimalen Trägerwert und dem Trägerrestwert aufzuheben und so den direkten Zusammenhang zwischen Trägerrestwert und Energieersparnis aufzulösen. Die Energieersparnis wird auf diese Weise mit einem weiter abgesenkten minimalen Trägerwert optimiert, während der Störspannungsabstand durch einen erhöhten Trägerrestwert auf einem ausreichend hohen Niveau gehalten werden kann.

Gemäss der Erfindung wird dabei auf der statischen Kennlinie der Trägerwert, ausgehend von Trägerrestwert, bis zu einem zweiten Pegelwert, der kleiner ist als der erste Pegelwert, proportional zum Modulationspegel abgesenkt, und ist für Modulationspegel zwischen dem zweiten Pegelwert und dem ersten Pegelwert konstant und gleich dem minimalen Trägerwert.

In einer bevorzugten Ausgestaltung enthalten die Mittel zur Trägersteuerung einen Gleichrichter zur Gleichrichtung des Modulationssignals, einen nachgeschalteten Spitzenwertdetektor zur Messung des Scheitelwertes des Modulationssignals und einen Steuerblock, der nach Massgabe des Scheitelwertes der Modulationsamplitude und gemäss der statischen Kennlinie an einem Ausgang ein Steuersignal für die Steuerung des Trägers abgibt.

Zur Reduktion der Übergangsverzerrungen und damit der Nebenausstrahlungen bei einem plötzlichen Pegelanstieg ist es vorteilhaft, wenn der Steuerblock erste Mittel zur Absenkung des Trägerwertes vom Trägerrestwert auf den minimalen Trägerwert, zweite Mittel zur Aufwärtssteuerung des Trägerwertes für Modulationspegel oberhalb des ersten Pegelwertes und dritte Mittel zur Vorgabe des minimalen Trägerwertes aufweist, und wenn die Absenkung des Trägerwertes mit den ersten Mitteln gegenüber dem Anstieg des Modulationspegels zeitlich verzögert erfolgt.

In dem gleichen Sinn ist es auch besonders vorteilhaft, wenn die Aufwärtssteuerung des Trägerwertes mit den zweiten Mitteln in Abhängigkeit von der Anstiegszeit des Modulationspegels in der Weise erfolgt, dass, abweichend von der statischen Kennlinie, die Aufwärtssteuerung bei umso kleineren Werten des Modulationspegels einsetzt, je kürzer die Anstiegszeit des Modulationspegels ist, und bei den kürzesten auftretenden Anstiegszeiten der Trägerwert vom Trägerrestwert aus unmittelbar aufwärts gesteuert wird.

Diese dynamische Steuerung bewirkt, dass zur Verminderung der Übergangsverzerrungen nur dann die statische Kennlinie verlassen wird, wenn es unbedingt notwendig ist und erreicht so eine optimale Energieeinsparung bei minimalen Verzerrungen in der Übertragung.

Die Erfindung soll nachfolgend anhand der Zeichnung näher beschrieben und in Ausführungsbeispielen und weiteren Ausgestaltungen erläutert werden. Es zeigen:

Fig. 1 die Arten der Trägersteuerung nach dem Stand der Technik,

Fig. 2 eine verbesserte Trägersteuerung mit einer allgemeinen Form der statischen Kennlinie,

Fig. 3 die statische Kennlinie nach der Erfindung und den Bereich der dynamischen Steuerung,

Fig. 4 das Blockschaltbild eines Ausführungsbeispiels der Trägersteuerung nach der Erfindung mit einem Steuerblock, und

Fig. 5 die bevorzugte schaltungsmässige Ausführung des Steuerblocks nach Fig. 4.

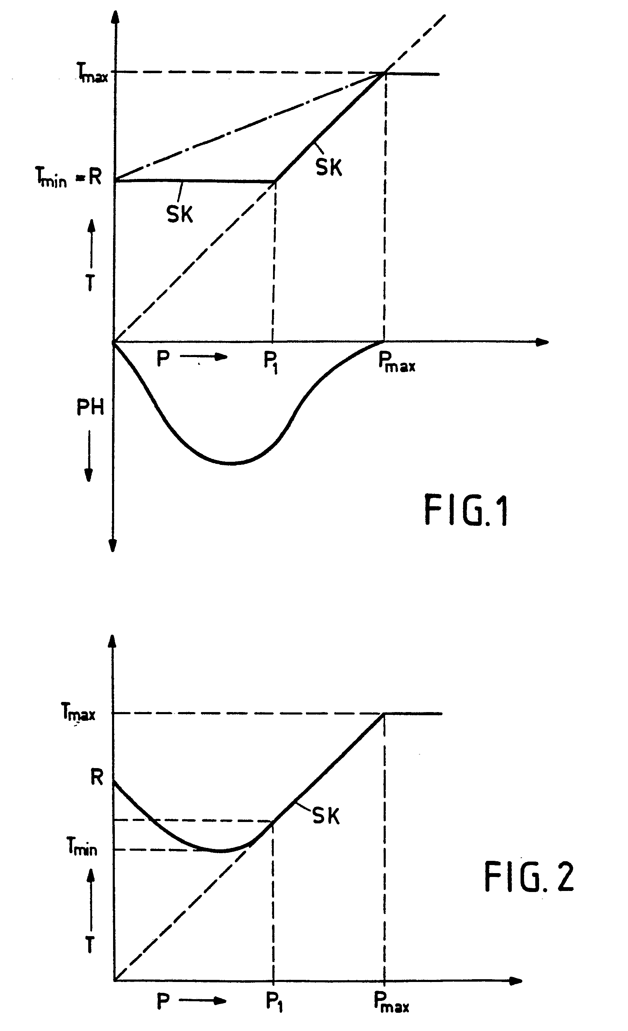

In Fig. 1 sind die bekannten Arten der Trägersteuerung anhand ihrer jeweiligen statischen Kennlinien dargestellt. Im oberen Teil des Diagramms ist der Trägerwert T in Abhängigkeit vom Modulationspegel P aufgetragen, im unteren Teil die Pegelhäuftigkeit PH. Ohne Trägersteuerung hat der Trägerwert T einen konstanten maximalen Trägerwert $T_{max}$. Die statische Kennlinie entspricht der gestrichelt eingezeichneten Horizontalen mit dem Abstand $T_{max}$ von der Abszisse. Bei der idealen Trägersteuerung, die keine Rücksicht auf Störungen und Empfängereigenschaften nimmt, verläuft die statische Kennlinie als Gerade durch den Ursprung und den Punkt mit maximalem Trägerwert $T_{max}$ und dem Pegelwert für $T_{max}$, $P_{max}$. Diese Gerade hat in der reduzierten Auftragung $T/T_{max}$ über $P/P_{max}$ die Steigung 1.

Das HAPUG-Verfahren, das demgegenüber gerade die Empfängereigenschaften (nichtlineare Gleichrichterkennlinie) berücksichtigt, steuert den Trägerwert T entlang der strichpunktierten Kennlinie, die als Gerade von einem Trägerrestwert R bei P = 0 ausgeht und gleichfalls den Punkt $(P_{max}, T_{max})$ berührt. Während bei der idealen Trägersteuerung der Modulationsgrad stets 100 % beträgt, nimmt er auf der HAPUG-Kennlinie mit steigendem Pegelwert P zu und erreicht erst bei $P_{max}$ den vollen Wert von 100 %. Zwischen den beiden Kennlinien liegt derjenige Bereich, in dem gegenüber dem HAPUG-Verfahren durch Absenkung des Trägerwertes T weitere Energieeinsparungen im Sendebetrieb erzielt werden können.

Die statische Kennlinie SK der verbesserten Trägersteuerung nach der DE-C-3 037 902 setzt sich im Extremfall aus einem horizontalen unteren Teil und einem oberen Teil zusammen, der entlang der idealen Trägersteuerungs-Kennlinie verläuft. Diese statische Kennlinie SK ist in Fig. 1 durchgezogen eingetragen. Der Trägerrestwert R ist, wie auch beim HAPUG-Verfahren, zugleich der minimale Trägerwert $T_{min}$, der während des Sendebetriebs angenommen wird.

Der horizontale Teil der statischen Kennlinie SK reicht von dem Modulationspegel P = 0 bis zu einem ersten Pegelwert $P_1$ und deckt damit einen Bereich ab, in dem die Pegelhäufigkeit PH (unterer Teil von Fig. 1) am grössten ist. Die Pegelhäufigkeitskurve gibt dabei die gemittelte Verteilung der Modulationspegel an, wie sie für ein Rundfunkprogramm über einen längeren Zeitraum gemessen wird.

Fig. 2 gibt in einer Fig. 1 entsprechenden schematischen Auftragung die statische Kennlinie SK wieder, die in allgemeiner Form eine verbesserte Trägersteuerung beschreibt. Der Kennlinienteil zwischen dem ersten Pegelwert $P_1$ und dem Punkt $(P_{max}, T_{max})$ ist wiederum ein Teil der idealen Trägersteuerungs-Kennlinie durch den Nullpunkt. Dazu muss ausdrücklich bemerkt werden, dass die tatsächliche Grösse des ersten Pegelwerts $P_1$ bei dieser Steuerung von dem aus den anderen Verfahren bekannten Wert abweicht und im allgemeinen kleiner ist als dieser.

Unterhalb des ersten Pegelwertes $P_1$ verläuft die statische Kennlinie SK flacher und durchläuft schliesslich im Bereich der am häufigsten vorkommenden Pegelwerte ein Minimum mit dem zugehörigen minimalen Trägerwert $T_{min}$. Jedoch wird dieser minimale Trägerwert $T_{min}$ nicht bis P = 0 eingenommen, sondern die statische Kennlinie SK steigt nach dem Durchlaufen von $T_{min}$ mit negativer Steigung auf einen Trägerrestwert R an, der deutlich grösser ist als $T_{min}$. Der Hauptvorteil dieses Kennlinienverlaufs ergibt sich aus einer gewissen Entkopplung der Grössen R und $T_{min}$. Aufgrund dieser Entkopplung kann der Trägerrestwert R, der den Störspannungsabstand am Empfangsort massgeblich beeinflusst, weitgehend unabhängig von dem minimalen Trägerwert $T_{min}$ optimiert, d. h. erhöht werden, während auf der anderen Seite der mit der Energieersparnis verknüpfte minimale Trägerwert $T_{min}$ gegenüber den anderen Verfahren entsprechend abgesenkt werden kann.

Wie ein Vergleich des Kennlinienverlaufs aus Fig. 2 mit der Funktion PH (P) aus Fig. 1 verdeutlicht, ist die statische Kennlinie SK nach Fig. 2 näherungsweise invers zur Häufigkeitsverteilung der Modulationspegel P, so dass der Trägerwert T gerade für diejenigen Pegelwerte am niedrigsten ist, die während eines üblichen Rundfunkprogramms auch am häufigsten auftreten, und nur in denjenigen Bereichen ansteigt, in denen ohnehin die erreichbare Energieeinsparung gering ist.

Die statische Kennlinie SK in ihrer allgemeinen Form gemäss Fig. 2 ist als eine Kurve dargestellt, die sowohl selbst als auch in ihrer 1. Ableitung stetig ist. Eine solche Kurve kann durch eine Vielzahl von linearen, überlagerten Kennlinienstücken approximiert werden. Für jedes dieser Kennlinienstücke ist dann ein eigener Funktionsgenerator notwendig, der eine in Steigung und Lage einstellbare Ausgangsfunktion erzeugt. Da jedoch kleine Änderungen im Verlauf der statischen Kennlinie (z. B. Unstetigkeitsstellen in der 1. Ableitung) nur einen geringen Einfluss auf die integrale Energieersparnis haben, ist es von Vorteil, sich bei der Approximation der Kurve nach Fig. 2 auf wenige Kennlinienstücke zu beschränken und damit den schaltungstechnischen Aufwand für die Steuerung in Grenzen zu halten.

Bei dem aus der GB-A-502 013 bekannten Verfahren wird die statische Kennlinie SK durch nur zwei Geraden approximiert. Dies bringt zwar die erwähnte Entkopplung, lässt aber einen weiten Bereich der Energieeinsparung ungenutzt.

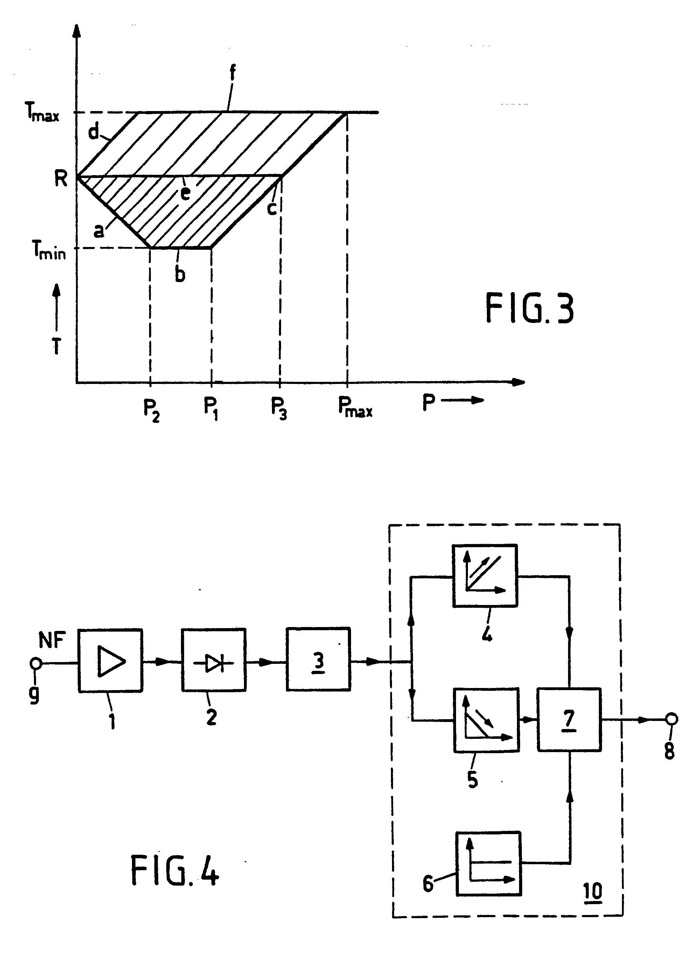

Gemäss der Erfindung werden für die Approximation, wie in Fig. 3 dargestellt, drei lineare Kennlinienabschnitte a, b und c verwendet, von denen der erste (a) mit negativer Steigung zwischen dem Punkt (P = 0, R) und einem Punkt$_2$, $T_{min}$) verläuft, der als Koordinaten einen zweiten Pegelwert $P_2$ und den minimalen Trägerwert $T_{min}$ hat. Der zweite Kennlinienabschnitt b mit der Steigung 0 verbindet die beiden Punkte ($P_2$, $T_{min}$) und ($P_1$, $T_{min}$). Der dritte Kennlinienabschnitt c schliesslich liegt in üblicher Weise, entlang der idealen Trägersteuerungs-Kennlinie, zwischen den Punkten ($P_1$, $T_{min}$) und ($P_{max}$, $T_{max}$) des P-T-Diagramms.

Die drei linearen Kennlinienabschnitte a, b und c bilden zusammen die statische Kennlinie SK nach der Erfindung gemäss Fig. 3. Dabei entspricht die Steigung des ersten Kennlinienabschnitts a dem Betrage nach der Steigung des dritten Kennlinienabschnitts c, hat also in der reduzierten Auftragung den Wert -1. In diesem Fall ist die Summe aus Trägerwert T und Modulationspegel P im Bereich des ersten Kennlinienabschnitts a konstant, so dass sich gerade in diesem kritischen Bereich kleiner Pegelwerte ein konstanter Störspannungsabstand ergibt.

Wie bereits ausführlich beschrieben worden ist, erlaubt die erfindungsgemässe Trägersteuerung eine getrennte Optimierung des Trägerrestwertes R und des minimalen Trägerwertes $T_{min}$. Als besonders günstig für den Betrieb des Senders hat es sich herausgestellt, wenn der Trägerrestwert R ungefähr gleich dem 0,75-fachen, und der minimale Trägerwert $T_{min}$ ungefähr gleich dem 0,5-fachen des maximalen Trägerwertes $T_{max}$ gewählt werden.

Das Blockschaltbild eines Ausführungsbeispiels der Trägersteuerung nach der Erfindung ist in Fig. 4 dargestellt. Auf einen Niederfrequenzeingang 9 wird das Modulationssignal in Form einer Niederfrequenz NF gegeben und gelangt über einen Vorverstärker 1 auf einen Gleichrichter 2, der in bekannter Weise als Zweiweggleichrichter ausgebildet sein kann. Der Gleichrichter 2 formt das niederfrequente Wechselspannunossignal in ein pulsierendes Gleichspannungssignal um, das auf den Eingang eines Spitzenwertdetektors 3 weitergeleitet wird. Der Spitzenwertdetektor 3 bildet aus dem pulsierenden Gleichspannungssignal ein Ausgangssignal, das in seinem zeitlichen Verlauf der Hüllkurve des ursprünglichen Modulationssignals entspricht. Durch eine einstellbare Zeitkonstante innerhalb des Spitzenwertdetektors 3 wird erreicht, dass extrem kurzzeitige Absenkungen im Modulationspegel P ausgeglichen werden.

Das Ausgangssignal des Spitzenwertdetektors 3 wird einem Steuerblock 10 zugeführt, der drei Funktionsgeneratoren 4, 5 und 6 sowie eine Überlagerungsschaltung 7 enthält. Die Funktionsgeneratoren erzeugen die in Fig. 3 eingezeichneten Kennlinienabschnitte a, b und c der statischen Kennlinie, die dann, in ihrer Lage und Steigung aufeinander abgestimmt, in der Überlagerungsschaltung 7 so überlagert werden, dass sich der Verlauf der statischen Kennlinie am Ausgang 8 des Steuerblocks 10 ergibt. Am Ausgang 8 wird ein Steuersignal abgenommen und der Trägerwert T proportional zu diesem Steuersignal gesteuert. Die Übertragungscharakteristik des Steuerblocks 10 entspricht daher direkt dem T(P)-Verlauf der Trägersteuerung.

Der erste Funktionsgenerator 4 besitzt die Übertragungsfunktion eines linearen nicht-invertierenden Verstärkers, d.h. er gibt an seinem Ausgang ein Signal ab, das proportional zum Ausgangssignal des Spitzenwertdetektors 3 ist. Er trägt damit zu der statischen Kennlinie denjenigen Kennlinienabschnitt bei, welcher der idealen Trägersteuerungs-Kennlinie entspricht, nämlich dem dritten Kennlinienabschnitt c.

Der zweite Funktionsgenerator 5 hat die Übertragungsfunktion eines linearen, invertierenden Verstärkers, dessen Ausgangssignal jedoch um einen konstanten, positiven Wert verschoben ist, der bei verschwindendem Eingangssignal angenommen wird. Dieser zweite Funktionsgenerator 5 trägt zu der statischen Kennlinie aus Fig. 3 den ersten Kennlinienabschnitt a bei. Die konstante, positive Verschiebung seines Ausgangssignals entspricht dem Trägerrestwert R.

Der dritte Funktionsgenerator 6 wird, im Unterschied zu den anderen beiden Funktionsgeneratoren 4 und 5, nicht von dem Spitzenwertdetektor 3 angesteuert. Er liefert lediglich ein von der Hüllkurve des Modulationssignals unabhängiges, konstantes und einstellbares Ausgangssignal, welches zur Vorgabe des minimalen Trägerwertes $T_{min}$ gemäss dem Kennlinienabschnitt b verwendet wird.

Die Ausgangssignale der drei Funktionsgeneratoren 4, 5 und 6 werden in der Überlagerungsschaltung 7 in der Weise überlagert, dass in Abhängigkeit vom Modulationspegel P zwischen P = 0 und P = $P_2$ nur der zweite Funktionsgenerator 5, zwischen P = $P_2$ und P = $P_1$ nur der dritte Funktionsgenerator 6, und oberhalb $P_1$ nur der erste Funktionsgenerator 4 zur Steuerung des Trägerwertes T beitragen. Eine Überlagerungsschaltung mit diesen Eigenschaften kann beispielsweise durch einen vom Modulationspegel P gesteuerten Umschalter realisiert werden.

Die bisherigen Ausführungen über die neuartige Trägersteuerung in einem amplitudenmodulierten Rundfunksender beschränkten sich auf die statische Kennlinie, wie sie in Fig. 2 und in den Kennlinienabschnitten a, b und c der Fig. 3 zum Ausdruck kommt. Gemäss einer Weiterbildung der Erfindung wird zusätzlich zu dieser statischen Trägersteuerung, welche die unterschiedlichen Anstiegs- und Abfallzeiten des Modulationspegels P nicht berücksichtigt, eine dynamische Trägersteuerung eingeführt, die, ausgehend von der statischen Kennlinie, bei schnelleren Änderungen des Modulationspegels diese Kennlinie verlässt und den Trägerwert T jeweils so aufwärtssteuert, dass auch bei steilen Pegelanstiegen Übergangsverzerrungen und damit Nebenausstrahlungen weitgehend vermieden werden.

Zu diesem Zweck wird die Abwärtssteuerung gemäss dem ersten Kennlinienabschnitt a gegenüber dem Hüllkurvensignal aus dem Spitzenwertdetektor 3 zeitlich verzögert. Dies geschieht beispielsweise durch ein in den zweiten Funktionsgenerator 5 eingebautes Zeitglied. Erfolgt der Pegelanstieg dann mit einer Zeitkonstante, die deutlich unterhalb der Zeitkonstanten dieses Zeitgliedes liegt, spricht der Funktionsgenerator 5 in dem ihm zugeordneten Pegelwertbereich nicht mehr an. Die Abwärtssteuerung wird nicht mehr eingeleitet, weil der Modulationspegel P nach Ablauf der Verzögerungszeit bereits oberhalb des zweiten Pegelwertes $P_2$ und damit im Bereich eines anderen Kennlinienabschnitts liegt.

Bei einer entsprechenden Ausführung der Überlagerungsschaltung 7 führt die interne Verzögerung im zweiten Funktionsgenerator 5, z. B. zu einem dynamischen Kennlinienabschnitt e, wie er in Fig. 3 als horizontale Gerade durch den Punkt (O, R) eingetragen ist. Zu diesem Zweck muss die Überlagerungsschaltung 7 so ausgelegt sein, dass immer das Ausgangssignal gerade desjenigen Funktionsgenerators an den Ausgang 8 weitergeleitet wird, das von den drei Ausgangssignalen am grössten ist.

Wird der Modulationspegel P von P = 0 sehr schnell auf einen dritten Pegelwert $P_3$ erhöht, steht wegen der internen Zeitverzögerung im Funktionsgenerator 5 das Ausgangssignal am Ausgang 8 an, das dem Trägerrestwert R entspricht und in dem Pegelbereich 0-$P_3$ von allen Ausgangssignalen den grössten Wert hat. Bei weiterer Erhöhung des Modulationspegels über $P_3$ hinaus wird dieses Ausgangssignal von dem dann grösseren Ausgangssignal des ersten Funktionsgenerators 4 abgelöst, das gemäss dem Kennlinienabschnitt c den Träger aufwärtssteuert. Das Ausgangssignal des dritten Funktionsgenerators 6 ist bei dieser dynamischen Steuerung für alle Modulationspegel kleiner als die anderen Ausgangssignale und wird dementsprechend in der Überlagerungsschaltung 7 nicht berücksichtigt. Der Trägerwert T wird also in diesem Fall entlang des dynamischen Kennlinienabschnitts e und weiter auf den dritten Kennlinienabschnitt c der statischen Kennlinie aufwärtsgesteuert.

Erfolgt der steile Anstieg des Modulationspegels P nicht von P = 0 aus, sondern von einem zwischen P = 0 und $P_2$ liegenden Pegelwert, ergibt sich ein zum Kennlinienabschnitt e paralleles, aber tiefer liegendes Kurvenstück, so dass bei dieser Art der dynamischen Steuerung, abhängig vom Ausgangspegel und der Anstiegssteilheit, der gesamte, in Fig. 3 doppelt schraffierte Bereich zwischen den Kennlinienabschnitten a, b, c und e für die Trägersteuerung zur Verfügung steht. Die partielle Überbrückung der Bereiche des Trägerwertes T, die den statischen Kennlinienabschnitten a, b, und c zugeordnet sind, verringert entscheidend die Übernahmeverzerrungen, die sonst bei einem steilen Pegelanstieg und einer Trägersteuerung entlang der statischen Kennlinie entstehen würden.

Gemäss einer anderen Weiterbildung der Erfindung kann eine weitere Reduktion der Übernahmeverzerrungen dadurch erreicht werden, dass bei den kürzeren auftretenden Anstiegszeiten des Modulationspegels P der Trägerwert T nicht erst bei Pegelwerten zwischen $P_1$ und $P_{max}$ aufwärtsgesteuert wird, sondern bereits bei kleinerem Modulationspegel. Im Grenzfall der kürzesten auftretenden Anstiegszeiten wird der Trägerwert T entlang der dynamischen Kennlinienabschnitte d und f aus Fig. 3 angehoben. Dadurch steht bei der dynamischen Steuerung zusätzlich zu dem doppelt schraffierten auch noch das einfach schraffierte Kennlinienfeld aus der Fig. 3 zur Verfügung. Die beiden Grenzfälle der langsamen und der sehr schnellen Pegeländerung sind durch die statische Kennlinie mit den Kennlinienabschnitten a, b, und c bzw. durch die dynamischen Kennlinienabschnitte d und f gekennzeichnet.

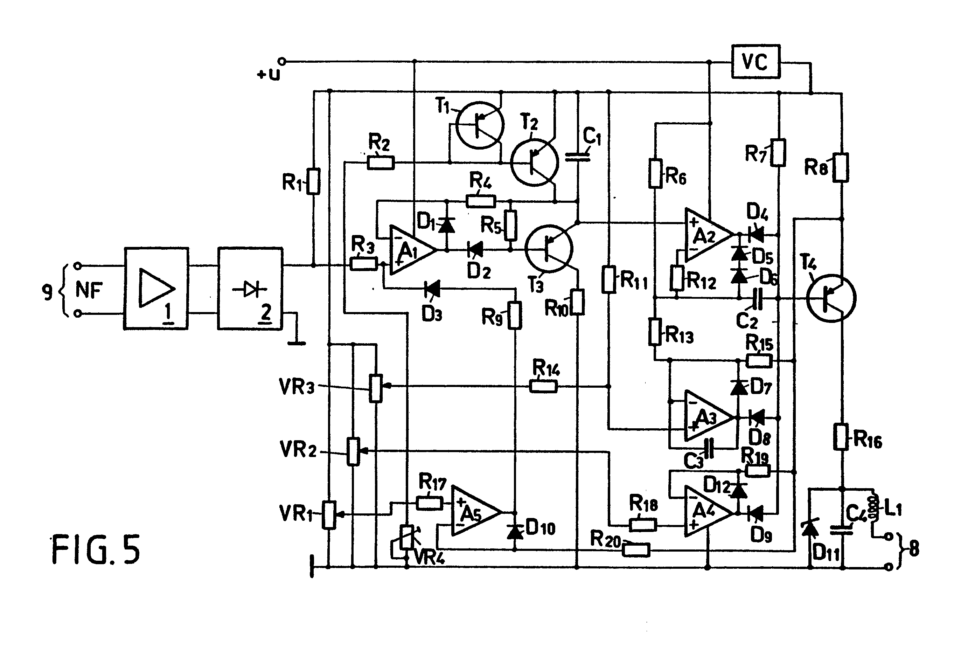

Eine bevorzugte Ausführung des Steuerblocks 10 ist in Fig. 5 dargestellt. Der Vorverstärker 1 und der Gleichrichter 2 sind in dieser Darstellung lediglich als Funktionsblöcke dargestellt, weil sie vom Fachmann ohne Schwierigkeiten in bekannter Weise ausgeführt werden können. Der Spitzenwertdetektor 3 aus der Fig. 4 ist aufgebaut aus einem Differenzverstärker A1 mit entsprechenden Vorwiderständen R1 und R3, der als Spannungsfolger über Dioden D1 und D2, Widerstände R4 und R5 und einen Transistor T3 einen Kondensator C1 auf die Spitzenspannung der pulsierenden Gleichspannung aus dem Gleichrichter 2 auflädt. Der Kondensator C1, der als Spitzenwertspeicher arbeitet, wird über eine bekannte Stromspiegel-Schaltung mit Transistoren $T_1$ und $T_2$ mit einer Zeitkonstante entladen, die über einen Vorwiderstand R2 mittels eines einstellbaren Widerstands VR4 vorgegeben werden kann.

Der im Kondensator C1 gespeicherte Spitzenwert bzw. Hüllkurvenwert wird am Emitter des Transistors T3 abgenommen und auf den nicht-invertierenden Eingang eines ersten Differenzverstärkers A2 gegeben, der über Dioden D5 und D6 und einen Widerstand R12 gegengekoppelt ist. Der erste Differenzverstärker A2 übernimmt die Aufgabe des ersten Funktionsgenerators 4 aus Fig. 4 und arbeitet als nicht-invertierender Verstärker zur Erzeugung des statischen Kennlinienabschnitts c.

Das Ausgangssignal des ersten Differenzverstärkers A2 gelangt über einen Widerstand R13 auf den invertierenden Eingang eines zweiten Differenzverstärkers A3, der als invertierender Verstärker geschaltet ist. Er übernimmt die Aufgabe des zweiten Funktionsgenerators 5, indem er den vom ersten Differenzverstärker A2 erzeugten Kennlinienabschnitt an der x-Achse spiegelt. Die notwendige Verschiebung dieser gespiegelten Kennlinie um einen konstanten Betrag wird durch eine konstante Vorspannung am nicht-invertierenden Eingang des zweiten Differenzverstärkers A3 erreicht, die mittels eines Spannungsteilers VR3 über Widerstände R11 und R14 eingestellt werden kann.

Die Funktion des dritten Funktionsgenerators 6 erfüllt ein dritter Differenzverstärker A4 in Spannungsfolger-Schaltung, dessen Eingangsspannung mittels eines Spannungsteilers VR2 über einen Widerstand R18 vorgegeben wird.

Die Überlagerungsschaltung 7 zur Überlagerung der Ausgangssignale der drei Funktionsgeneratoren 4, 5 und 6 bzw. der drei Differenzverstärker A2, A3 und A4 umfasst drei Dioden D4, D8 und D9, die von den Ausgängen der Differenzverstärker auf einen gemeinsamen Summationspunkt geschaltet sind und von dort über die Basis einen Transistor T4 ansteuern, der das am Ausgang 8 zur Verfügung stehende Steuersignal für die Trägersteuerung erzeugt.

Die Differenzverstärker A2, A3 und A4 stellen zusammen mit den Dioden D4, D8 und D9 das gewünschte Funktionsnetzwerk dar, mit dem die statische Kennlinie aus den linearen Kennlinienabschnitten a, b und c zusammengesetzt wird. Die dynamische Steuerung in dem schraffierten Bereich aus Fig. 3 wird durch zwei Kondensatoren C2 und C3 erreicht, die in spezieller Weise mit den Differenzverstärkern A2 und A3 verschaltet sind.

Der Kondensator C2 liegt parallel zu der Diode D4, die den Ausgang des Differenzverstärkers A2 mit dem Summationspunkt verbindet. Während ohne C2 das Ausgangssignal von A2 nur dann an den als Stromquelle geschalteten Transistor T4 weitergeleitet wird, wenn es grösser ist, als die Ausgangssignale der beiden anderen Differenzverstärker A3 und A4, wird durch den Kondensator C2 bei einem steilen Anstieg des Modulationspegels P die sperrende Diode D4 mehr oder weniger stark kurzgeschlossen, so dass die Aufwärtssteuerung des Trägerwertes T in diesem Fall bereits unterhalb des ersten Pegelwertes $P_1$ beginnt.

Der Kondensator C3 liegt in der Rückkopplungsleitung des zweiten Differenzverstärkers A3 und bewirkt die zeitliche Verzögerung der Abwärtssteuerung gegenüber dem Modulationspegel P. In einer erprobten Ausführung der Schaltung nach Fig. 5 wurde ein Kondensator C2 mit einer Kapazität von 0,22 $\mu$F verwendet, was einer charakteristischen Anstiegszeit von etwa 2 ms entspricht. Für den Kondensator C3 erwies sich ein Kapazitätswert von 47 nF im Zusammenhang mit einem Widerstand R13 von 100 k$\Omega$ als besonders günstig. Innerhalb des Spitzenwertdetektors 3 wurden gute Resultate mit einem Kondensator C1 von 1 $\mu$F bei einem Kollektorwiderstand R10 des Transistors T3 von 100 $\Omega$ erzielt. Als Transistoren T1 - T4 wurden pnp-Transistoren vom Typ BCY 79 eingesetzt.

Zur Begrenzung gegen eine Übersteuerung ist in der Schaltung nach Fig. 5 zusätzlich ein Begrenzer vorgesehen, der im wesentlichen aus einem weiteren Differenzverstärker A5 besteht. Der Differenzverstärker A5 erhält auf seinen nicht-invertierenden Eingang über einen Widerstand R17 eine einstellbare Referenzspannung, die an einem Spannungsteiler VR1 abgegriffen wird. Der invertierende Eingang ist über Widerstände R20, R19 und R15 und Dioden D7 und D12 mit den Ausgängen des zweiten und dritten Differenzverstärkers A3 bzw. A4 verbunden. Der Ausgang von A5, über eine Diode D10 gegengekoppelt, führt über einen Widerstand R9 und eine weitere Diode D3 auf den nicht-invertierenden Eingang des Differenzverstärkers A1 im Spitzenwertdetektor 3.

In der Kollektorleitung des Transistors T4 ist zum Schutz der Schaltung gegen hochfrequente Störungen aus der Senderstufe eine HF-Sperre, bestehend aus einer Induktivität L1 mit etwa 33 uH und ein Kondensator C4 mit einer Kapazität von etwa 10 nF vorgesehen. Die HF-Sperre ist zusätzlich durch eine Zenerdiode D11 überbrückt, um die Funktionstüchtigkeit der Schaltung unabhängig von der am Ausgang 8 liegenden Impedanz zu gewährleisten. Schliesslich kann auch in die Zuführungsleitung für die Versorgungsspannung U noch ein Spannungskonstanter, z. B. vom Typ LM 317, eingesetzt werden, um die Genauigkeit der Steuerung zu erhöhen.

**Patentansprüche**

1. Amplitudenmodulierter Sender mit Steuerung des Trägerwertes (T) durch den Modulationspegel (P), bei welcher Steuerung die statische Kennlinie (SK) des Trägerwertes (T) in Abhängigkeit vom Modulationspegel (P) zwischen einem maximalen Trägerwert ($T_{max}$) und einem minimalen Trägerwert ($T_{min}$), der grösser ist als Null, verläuft, und oberhalb eines ersten Pegelwertes ($P_1$) der Trägerwert (T) auf der statischen Kennlinie (SK) proportional zum Modulationspegel (P) aufwärtsgesteuert wird, und bei welcher Steuerung der minimale Trägerwert ($T_{min}$) im Bereich der am häufigsten auftretenden Werte des Modulationspegels (P) angenommen wird, und Mittel zur Trägersteuerung vorgesehen sind derart, dass bei verschwindendem Modulationspegel (P) ein Trägerrestwert (R) verbleibt, der grösser ist als der minimale Trägerwert ($T_{min}$), und dass der Trägerwert (T) auf der statischen Kennlinie (SK), ausgehend von dem Trägerrestwert (R), mit steigendem Modulationspegel (P) zunächst auf den minimalen Trägerwert ($T_{min}$) abgesenkt wird, dadurch gekennzeichnet, dass der Trägerwert (T), ausgehend vom Trägerrestwert (R), bis zu einem zweiten Pegelwert ($P_2$), der kleiner ist als der erste Pegelwert ($P_1$), proportional zum Modulationspegel (P) abgesenkt wird, und dass für Modulationspegel (P) zwischen dem zweiten Pegelwert ($P_2$) und dem ersten Pegelwert ($P_1$) der Trägerwert (T) konstant und gleich dem minimalen Trägerwert ($T_{min}$) ist.

2. Sender nach Anspruch 1, dadurch gekennzeichnet, dass die Steigung der statischen Kennlinie (SK) unterhalb des zweiten Pegelwertes ($P_2$) und oberhalb des ersten Pegelwertes ($P_1$) dem Betrage nach gleich sind.

3. Sender nach einem der Ansprüche 1 und 2, dadurch gekennzeichnet, dass der Trägerrestwert (R) ungefähr gleich dem 0,75-fachen des maximalen Trägerwertes ($T_{max}$) und der minimale Trägerwert ($T_{min}$) ungefähr gleich dem 0,5-fachen des maximalen Trägerwertes ($T_{max}$) sind.

4. Sender nach einem der Ansprüche 1 bis 3, dadurch gekennzeichnet, dass die Mittel zur Trägersteuerung einen Gleichrichter (2) zur Gleichrichtung des Modulationssignals, einen dem Gleichrichter (2) nachgeschalteten Spitzenwertdetektor (3) zur Messung des Scheitelwertes des Modulationssignals, und einen Steuerblock (10) enthalten, welcher nach Massgabe des Scheitelwertes und gemäss der statischen Kennlinie (SK) an einem Ausgang (8) ein Steuersignal für die Steuerung des Trägers abgibt.

5. Sender nach Anspruch 4, dadurch gekennzeichnet, dass innerhalb des Steuerblocks (10) erste Mittel zur Absenkung des Trägerwertes (T) vom Trägerrestwert (R) auf den minimalen Trägerwert ($T_{min}$), zweite Mittel zur Aufwärtssteuerung des Trägerwertes (T) für Modulationspegel (P) oberhalb des ersten Pegelwertes ($P_1$) und dritte Mittel zur Vorgabe des minimalen Trägerwertes ($T_{min}$) vorgesehen sind, und dass die Absenkung des Trägerwertes (T) mit den ersten Mitteln gegenüber dem Anstieg des Modulationspegels (P) zeitlich verzögert erfolgt.

6. Sender nach Anspruch 5, dadurch gekennzeichnet, dass die Aufwärtssteuerung des Trägerwertes (T) mit den zweiten Mitteln in Abhängigkeit von der Anstiegszeit des Modulationspegels (P) in der Weise erfolgt, dass, abweichend von der statischen Kennlinie (SK), die Aufwärtssteuerung bei umso kleineren Werten des Modulationspegels (P) einsetzt, je kürzer die Anstiegszeit ist, und dass bei den kürzesten auftretenden Anstiegszeiten der Trägerwert (T) vom Trägerrestwert (R) aus unmittelbar aufwärtsgesteuert wird.

7. Sender nach Anspruch 4, dadurch gekennzeichnet, dass der Steuerblock (10) ein Funktionsnetzwerk mit mehreren Differenzverstärkern (A2 ... A4) umfasst, von denen ein erster Differenzverstärker (A2) in nicht-invertierender Anordnung zur Aufwärtssteuerung, ein zweiter Differenzverstärker (A3), in invertierender Anordnung nachfolgend, zur Absenkung, und ein dritter Differenzverstärker (A4) als Spannungsfolger zur Vorgabe des minimalen Trägerwertes ($T_{min}$) verwendet werden, und dass die Ausgangssignale der Differenzverstärker (A2 ... A4) in einer Überlagerungsschaltung (7) zur Bildung der statischen Kennlinie (SK) überlagert werden.

8. Sender nach Anspruch 7, dadurch gekennzeichnet, dass die Überlagerungsschaltung (7) eine Mehrzahl von Dioden (D4, D8, D9) aufweist, welche Dioden (D4, D8, D9), von einem gemeinsamen Summationspunkt ausgehend, einzeln mit den Ausgängen der Differenzverstärker (A2 ... A4) verbunden sind, dass die dem ersten Differenzverstärker (A2) zugeordnete Diode (D4) durch einen ersten Kondensator (C2) wechselspannungsmässig überbrückt ist, und dass der Ausgang des zweiten Differenzverstärkers (A3) durch einen zweiten Kondensator (C3) auf den invertierenden Eingang rückgekoppelt ist.

9. Sender nach Anspruch 8, dadurch gekennzeichnet, dass der erste Kondensator (C2) eine Kapazität von ungefähr 0,2 µF und der zweite Kondensator (C3) eine Kapazität von ungefähr 50 nF aufweist.

## Claims

1. An amplitude-modulating transmitter in which the carrier value (T) is controlled by the modulation level (P), in which control system the static characteristic (SK) of the carrier value (T) varies as a function of the modulation level (P) between a maximum carrier value ($T_{max}$) and a minimum carrier value ($T_{min}$) which is greater than zero and the carrier value (T) on the static characteristic (SK) is forward-controlled proportionally to the modulation level (P) above a first level value ($P_1$) and in which control system the minimum carrier value ($T_{min}$) is assumed to occur in the region of the most frequently occurring values of the modulation (P), and means are provided for controlling the carrier in such a manner that with a disappearing modulation level (P) a residual carrier value (R) remains which is greater than the minimum carrier value ($T_{min}$) and that the carrier value (T) is initially reduced on the static characteristic (SK), starting from the residual carrier value (R), to the minimum carrier value ($T_{min}$) with rising modulation level (P), characterized in that the carrier value (T) is reduced, starting from the residual carrier value (R), proportionally to the modulation level (P) to a second level value ($P_2$) which is lower than the first level value ($P_1$) and that the carrier value (T) is constant and equal to the minimum carrier value ($T_{min}$) for modulation levels (P) between the second level value ($P_2$) and the first level value ($P_1$).

2. A transmitter according to Claim 1, characterized in that the slope (sic) of the static characteristic (SK) are equal in amount below the second level value ($P_2$) and above the first level value ($P_1$).

3. A transmitter according to one of Claims 1 and 2, characterized in that the residual carrier value (R) is approximately equal to 0.75 times the maximum carrier value ($T_{max}$) and the minimum carrier value ($T_{min}$) is approximately equal to 0.5 times the maximum carrier value ($T_{max}$).

4. A transmitter according to one of Claims 1 to 3, characterterised in that the means for controlling the carrier contain a rectifier (2) for rectifying the modulation signal, a peak detector (3), which follows the rectifier (2), for measuring the peak value of the modulation signal and a control block (10) which supplies at an output (8) a control signal for controlling the carrier as determined by the peak value and in accordance with the static characteristic (SK).

5. A transmitter according to Claim 4, characterized in that within the control block (10) first means for lowering the carrier value (T) from the residual carrier value (R) to the minimum carrier value ($T_{min}$), second means for forward-controlling the carrier value (T) for modulation levels (P) above the first level value ($P_1$) and third means for predetermining the minimum carrier value ($T_{min}$) are provided, and that the lowering of the carrier value (T) is carried out by the first means with a time delay with respect to the rise in the modulation level (P).

6. A transmitter according lo Claim 5, characterized in that the forward control of the carrier value (T) by the second means is carried out as in dependence of the rise time of the modulation level (P) in such a manner that, deviating from the static characteristic (SK), the forward control starts at values of the modulation level (P) which are ever lower the shorter the rise time and that with the shortest occurring rise times, the carrier value (T) is directly forward-controlled from the residual carrier value (R).

7. A transmitter according to Claim 4, characterized in that the control block (10) comprises a function network having several differential amplifiers (A2...A4) of which a first differential amplifier (A2) is used in non-inverting arrangement for forward-controlling, a second differential amplifier (A3), following in inverting arrangement, is used for lowering, and a third differential amplifier (A4) is used as a voltage follower für presetting the minimum carrier value ($T_{min}$) and that the output signals of the differential amplifiers (A2...A4) are mixed in a mixing circuit (7) for forming the static characteristic (SK).

8. A transmitter according to Claim 7, characterized in that the mixing circuit (7) has a plurality of diodes (D4, D8, D9), which diodes (D4, D8, D9), starting from a common summing point, are individually connected to the outputs of the differential amplifiers (A2...A4), that the diode (D4) associated with the first differential amplifier (A2) is bridged with respect to alternating voltage by a first capacitor (C2) and that the output of the second differential amplifier (A3) is fed back to the inverting input through a second capacitor (C3).

9. A transmitter according to Claim 8, characterized in that the first capacitor (C2) has a capacity of approximately 0.2 µF and the second capacitor (C3) has a capacity of approximately 50 nF.

## Revendications

1. Emetteur à modulation d'amplitude à commande de la valeur de porteuse (T) par le niveau de modulation (P), dans laquelle commande la caractéristique statique (SK) de la valeur de porteuse (T) en fonction du niveau de modulation (P) s'étend entre une valeur maximale ($T_{max}$) de la porteuse et une valeur minimale ($T_{min}$) de la porteuse qui est supérieure à zéro, et la valeur de porteuse (T) est commandée, au-dessus d'un premier niveau ($P_1$), en sens croissant suivant la caractéristique statique (SK), proportionnellement au niveau de modulation (P), et dans laquelle commande la valeur minimale ($T_{min}$) de la porteuse est adoptée dans le domaine des niveaux de modulation (P) les plus fréquents, et des moyens pour la commande de porteuse sont prévus d'une manière telle que lorsque le niveau de modulation (P) disparaît, il subsiste une valeur résiduelle (R) de la porteuse qui est supérieure à la valeur minimale ($T_{min}$) de la porteuse et qu'en cas de croissance du niveau de modulation (T), la valeur de porteuse (T) soit d'abord abaissée suivant la caractéristique statique (SK), au départ de la valeur résiduelle (R) de la porteuse, jusqu'à la valeur minimale ($T_{min}$) de la porteuse, caractérisé en ce que jusqu'à un deuxième niveau ($P_2$), qui est inférieur au premier niveau ($P_1$) la valeur de porteuse (T) est abaissée depuis la valeur résiduelle R, proportionnellement au niveau de modulation (P), et que, pour un niveau de modulation (P) compris entre le deuxième niveau ($P_2$) et le premier niveau ($P_1$), la valeur de porteuse (T) est constante et égale à la valeur minimale ($T_{min}$) de porteuse.

2. Emetteur suivant la revendication 1, caractérisé en ce que la pente de la caractéristique statique (SK) est la même en valeur absolue en dessous du deuxième niveau ($P_2$) et au-dessus du premier niveau ($P_1$).

3. Emetteur suivant l'une quelconque des revendications 1 et 2, caractérisé en ce que la valeur résiduelle (R) de la porteuse est environ égale à 0,75 fois la valeur maximale ($T_{max}$) de la porteuse et la valeur minimale ($T_{min}$) de la porteuse est environ égale à 0,5 fois la valeur maximale ($T_{max}$) de la porteuse.

4. Emetteur suivant l'une quelconque des revendications 1 à 3, caractérisé en ce que les moyens de commande de porteuse comprennent un redresseur (2) pour redresser le signal de modulation, un détecteur de valeurs de pointe (3) suivant le redresseur (2) pour mesurer la valeur maximale du signal de modulation et un bloc de commande (10) qui fournit sur une sortie (8) un signal de commande pour la commande de porteuse en fonction de la valeur maximale et suivant la caractéristique statique (SK).

5. Emetteur suivant la revendication 4, caractérisé en ce que dans le bloc de commande (10) sont prévus des premiers moyens pour abaisser la valeur de porteuse (T) depuis la valeur résiduelle (R) de la porteuse jusqu'à la valeur minimale ($T_{min}$) de la porteuse, des deuxièmes moyens pour commander la valeur de porteuse (T) en sens croissant pour des niveaux de modulation (P) supérieurs au premier niveau ($P_1$) et des troisièmes moyens pour prédéfinir la valeur minimale ($T_{min}$) de la porteuse, et que l'abaissement de la valeur de porteuse (T) par les premiers moyens s'effectue avec un certain retard par rapport à la montée du niveau de modulation (P).

6. Emetteur suivant la revendication 5, cacactérisé en ce que la commande en sens croissant de la valeur de porteuse (T) par les deuxièmes moyens est effectuée en fonction du temps de montée du niveau de modulation (P) d'une manière telle que, sans suivre la caractéristique statique (SK), la commande en sens croissant débute pour des niveaux de modulation (P) d'autant plus bas que le temps de montée est court et que, pour les temps de montée les plus courts, la valeur de porteuse (T) est commandée en sens croissant directement à partir de la valeur résiduelle (R) de la porteuse.

7. Emetteur suivant la revendication 4, caractérisé en ce que le bloc de commande (10) comprend un réseau de fonctions de plusieurs amplificateurs différentiels (A2 ... A4), parmi lesquels un premier amplificateur différentiel (A2) en montage non inverseur est utilisé pour la commande en sens croissant, un deuxième amplificateur différentiel (A3) suivant en montage inverseur est utilisé pour l'abaissement et un troisième amplificateur différentiel (A4) est utilisé comme suiveur de tension pour prédéfinir la valeur minimale ($T_{min}$) de la porteuse, et que les signaux de sortie des amplificateurs différentiels (A2 ... A4) sont superposés dans un circuit de superposition (7) pour former la caractéristique statique (SK).

8. Emetteur suivant la revendication 7, caractérisé en ce que le circuit de superposition (7) comporte plusieurs diodes (D4, D8, D9) qui, au départ d'un point de sommation commun, sont connectées individuellement aux sorties des amplificateurs différentiels (A2 ... A4), que la diode (D4) associée au premier amplificateur différentiel (A2) est pontée en tension alternative par un premier condensateur (C2) et que la sortie du deuxième amplificateur différentiel (A3) est couplée en retour par un deuxième condensateur (C3) à l'entrée inverseuse.

9. Emetteur suivant la revendication 8, caractérisé en ce que le premier condensateur (C2) a une capacité d'environ 0,2 µF et le deuxième condensateur (C3) à une capacité d'environ 50 nF.

EP 0 137 121 B1

FIG.1

FIG. 2

FIG.3

FIG.4

FIG.5

EP 0 137 121 B1